# EUROPEAN PATENT SPECIFICATION

(11) **EP 4 075 491 B1**
(45) Date of publication and mention of the grant of the patent: **25.11.2026**
(21) Application number: 22165060.9
(22) Date of filing: 11.10.2016
(51) Int. Cl.: H10D 84/01, G06F 30/392, H10D 84/03, H10D 84/85, H10D 89/10, H10W 20/00, H10W 20/40, H10W 20/41

(54) **POWER RAIL INBOUND MIDDLE OF LINE (MOL) ROUTING**
ROUTEN VON EINGEHENDER LEITUNGSMITTE (MOL) BEI EINER STROMSCHIENE
ROUTAGE DE MILIEU DE LA LIGNE (MOL) ENTRANTE DE RAIL D'ALIMENTATION

(30) Priority: 09.11.2015 US 201514936459
(43) Date of publication of application: 19.10.2022
(62) Document number(s) of the earlier application(s) in accordance with Art. 76 EPC: 16785314.2 / 3 375 009
(73) Proprietor: QUALCOMM Incorporated, San Diego, CA 92121-1714 (US)
(72) Inventor: LIM, Hyeokjin Bruce, San Diego, 92121-1714 (US); DUAN, Zhengyu, San Diego, 92121-1714 (US); YE, Qi, San Diego, 92121-1714 (US); MALABRY, Mickael, San Diego, 92121-1714 (US)
(74) Representative: Schmidbauer, Andreas Konrad

(56) References cited:
- US-A1- 2009 321 791
- US-A1- 2010 123 253
- US-A1- 2012 074 467
- US-A1- 2013 126 978
- US-A1- 2013 146 986
- US-A1- 2015 194 427
- US-A1- 2015 235 948
- US-B1- 9 070 552

## Description

### BACKGROUND

### Field

Aspects of the present disclosure relate generally to routing on a die, and more particularly, to middle of line (MOL) routing on a die.

### Background

A semiconductor die may include many semiconductor devices (e.g., transistors). The semiconductor devices may be interconnected by one or more metal layers to form integrated circuits. As the dimensions of devices scale down, routing congestion on a die increases, making it more difficult to interconnect devices on the die.

Attention is drawn to US 2015/194427 A1 describing semiconductor devices and methods of forming the same. The semiconductor devices may include a finFET, a metal routing layer, a first local interconnect layer, and a second local interconnect layer. The finFET may include a channel, a first source/drain region, a second source/drain region, and a gate stack. The metal routing layer may be separated from the finFET in a vertical direction. The first local interconnect layer may include a first local interconnect that contacts a first metal route in the metal routing layer and that electrically connects to the first source/drain region. The second local interconnect layer may include a second local interconnect that contacts a second metal route in the metal routing layer and that electrically connects to the gate stack.

### SUMMARY

The present invention is set forth in the independent claims 1 and 10, respectively. Preferred embodiments of the invention are described in the dependent claims.

The following presents a simplified summary of one or more embodiments in order to provide a basic understanding of such embodiments. This summary is not an extensive overview of all contemplated embodiments, and is intended to neither identify key or critical elements of all embodiments nor delineate the scope of any or all embodiments. Its sole purpose is to present some concepts of one or more embodiments in a simplified form as a prelude to the more detailed description that is presented later.

According to an aspect, a semiconductor die is provided. The semiconductor die includes a power rail, a first gate, and a second gate. The semiconductor die also includes a first gate contact electrically coupled to the first gate, wherein the first gate contact is formed from a first middle of line (MOL) metal layer, and a second gate contact electrically coupled to the second gate, wherein the second gate contact is formed from the first MOL metal layer. The semiconductor die further includes an interconnect formed from a second MOL metal layer, wherein the interconnect is electrically coupled to the first and second gate contacts, and at least a portion of the interconnect is underneath the power rail.

A second aspect relates to a semiconductor die. The semiconductor die includes a power rail, a gate, and a source. The semiconductor die also includes a gate contact electrically coupled to the gate, wherein the gate contact is formed from a first middle of line (MOL) metal layer. The semiconductor die also includes an interconnect formed from a second MOL metal layer, wherein the interconnect is electrically coupled to the gate contact and the source, and at least a portion of the interconnect is underneath the power rail.

A third aspect relates to a semiconductor die. The semiconductor die includes a power rail, a first cell including a first plurality of gates and a first plurality of sources/drains, and a second cell including a second plurality of gates and a second plurality of sources/drains. The semiconductor cell also includes a first gate contact electrically coupled to one of the first plurality of gates, wherein the first gate contact is formed from a first middle of line (MOL) metal layer, and a second gate contact electrically coupled to one of the second plurality of gates, wherein the second gate contact is formed from the first MOL metal layer. The semiconductor die also includes an interconnect formed from a second MOL metal layer, wherein the interconnect is electrically coupled to the first and second gate contacts, and is routed underneath the power rail.

### BRIEF DESCRIPTION OF THE DRAWINGS

FIG. 1 shows a side view of an exemplary semiconductor die according to certain aspects of the present disclosure.
FIG. 2 shows a side view of an exemplary structure for coupling a gate to a metal layer according to certain aspects of the present disclosure.
FIG. 3 shows a side view of an exemplary structure for coupling a source/drain to a metal layer according to certain aspects of the present disclosure.
FIG. 4 shows a top view of an exemplary semiconductor die according to certain aspects of the present disclosure.
FIG. 5 shows exemplary local interconnects formed from metal layer M1 according to certain aspects of the present disclosure.
FIGS. 6A and 6B show side views of the exemplary local interconnects in FIG. 5 according to certain aspects of the present disclosure.
FIG. 7 shows a top view of an exemplary interconnect formed from metal layer M1 and used for routing between cells according to certain aspects of the present disclosure.
FIGS. 8A and 8B show top views of an exemplary interconnect providing routing under a metal M1 power rail according to the invention.
FIG. 9 shows a side view of the interconnect in FIGS. 8A and 8B according to the invention.
FIGS. 10A and 10B show top views of another exemplary interconnect providing routing under a metal M1 power rail according to the invention.
FIG. 11 shows a side view of the interconnect in FIGS. 10A and 10B according to the invention.
FIG. 12 shows a circuit diagram of multiple transistors, in which the sources and gates of the transistors are tied off to provide an electrical barrier according to certain aspects of the present disclosure.
FIGS. 13A and 13B show top views of an interconnect under a metal M1 power rail for implementing the circuit in FIG. 12 according to the invention.
FIG. 14 shows a side view of the interconnect in FIGS. 13A and 13B according to the invention.

### DETAILED DESCRIPTION

The detailed description set forth below, in connection with the appended drawings, is intended as a description of various configurations and is not intended to represent the only configurations in which the concepts described herein may be practiced. The detailed description includes specific details for the purpose of providing a thorough understanding of the various concepts. However, it will be apparent to those skilled in the art that these concepts may be practiced without these specific details. In some instances, well-known structures and components are shown in block diagram form in order to avoid obscuring such concepts.

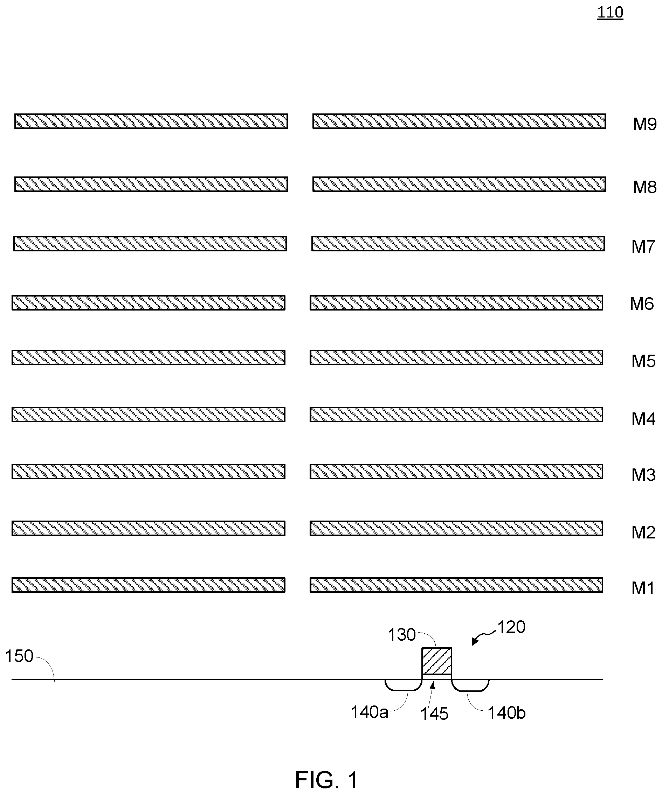

FIG. 1 shows a simplified example of a semiconductor die (chip) 110. The semiconductor die 110 includes multiple interconnect metal layers, in which adjacent interconnect metal layers are separated by one or more insulating layers. The different interconnect metal layers may be interconnected using vias and/or other structures, which are not shown in FIG. 1 for ease of illustration. The bottom-most interconnect metal layer is labeled M1. The interconnect metal layer immediately above interconnect metal layer M1 is labeled M2, the interconnect metal layer immediately above metal layer M2 is labeled M3, and so forth. In this example, the semiconductor die 110 includes nine interconnect metal layers labeled M1-M9.

The interconnect metal layers M1-M9 are used to couple various components of the die to one another, to one or more off-die devices, and/or to one or more power supplies. Typically, metal layer M1 is formed over semiconductor devices (e.g., transistors) on the die, and is coupled to the semiconductor devices using contact structures, as discussed further below. Metal layer M1 may be used to provide power rails for semiconductor devices on the die, to couple semiconductor devices on the die to one another, and/or to couple semiconductor devices on the die to higher metal layers. In this regard, FIG. 1 shows an example of a transistor 120 (e.g., field effect transistor) under metal layer M1. The transistor 120 is formed on a substrate 150 of the die before the metals M1-M9 are deposited over the transistor 120. The transistor 120 includes a gate 130, a first source/drain 140a, and a second source/drain 140b. The gate 130 may include polysilicon and/or other material. As used herein, the term "source/drain" indicates that the corresponding structure can act as a source or a drain. Although one transistor 120 is shown in FIG. 1 for ease of illustration, it is to be appreciated the semiconductor die 110 includes many transistors. It is also to be appreciated that FIG. 1 is not drawn to scale, and that the thicknesses of the metal layers M1-M9 and the spaces between adjacent metal layers may vary on the die.

The transistor 120 may be formed on the die using a planar process or a FinFET process. FIG. 1 shows an example in which the transistor 120 is formed using a planar process. In this example, the transistor 120 includes a gate dielectric 145 (e.g., gate oxide) between the gate and channel of the transistor. For a transistor formed using a FinFET process (not shown), the transistor may include one or more fins between the first source/drain and second source/drain to form the channel of the transistor, and a gate formed over the fins. In either case, a transistor includes a gate, a first source/drain, and a second source/drain. Accordingly, it is to be appreciated that aspects of the present disclosure are applicable to transistors formed using planar processes and FinFET processes.

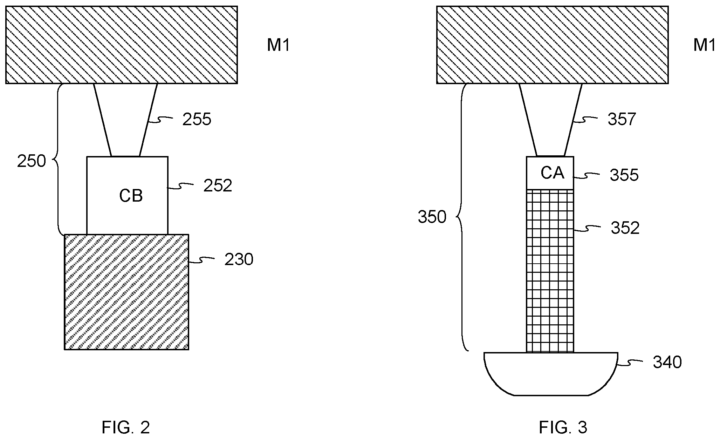

FIG. 2 shows an exemplary contact structure 250 for coupling a gate 230 of a transistor (e.g., transistor 120) to metal layer M1. In this example, the contact structure 250 is disposed between the gate 230 and metal layer M1, and electrically couples the gate 230 to metal layer M1. The contact structure 250 includes a gate contact 252 formed from a first middle of line (MOL) metal layer (denoted "CB" in FIG. 2). As used herein, the term "MOL" refers to a layer under metal layer M1. The first MOL metal layer (CB) may include tungsten, copper and/or other conductive material. The gate contact 252 may make contact with the top of the gate 230, as shown in FIG. 2. The contact structure 250 also includes a via 255 disposed between the gate contact 252 and metal layer M1. The via 255 electrically couples the gate contact 252 to metal layer M1.

FIG. 3 shows an exemplary contact structure 350 for coupling a source/drain 340 of a transistor (e.g., transistor 120) to metal layer M1. In this example, the contact structure 350 is disposed between the source/drain 340 and metal layer M1, and electrically couples the source/drain to metal layer M1. The contact structure 350 includes a first source/drain contact 352 formed on top of the source/drain 340. The first source/drain contact 352 may be formed from a trench silicide (TS) layer. In this example, the first source/drain contact 352 may be formed by etching a trench in a dielectric material and filling the trench with a silicide material. The contact structure 350 also includes a second source/drain contact 355 formed from a second MOL metal layer (denoted "CA" in FIG. 3). The second MOL metal layer (CA) may include tungsten, copper and/or other conductive material. The second source/drain contact 355 is stacked on top of the first source/drain contact 352 in the example in FIG. 2. The contact structure 350 further includes a via 357 disposed between the second source/drain contact 355 and metal layer M1. The via 357 electrically couples the second source/drain contact 355 to metal layer M1. The vias 255 and 357 in FIGS. 2 and 3 may be formed from the same conductive layer.

Thus, the first and second MOL metal layers (CB and CA) are conventionally used to couple the gates and sources/drains, respectively, to metal layer M1 and/or other upper metal layers. The first and second MOL metal layers (CB and CA) are not conventionally used to form a global feature. As used herein, a "global feature" may refer to a structure that is shared by multiple cells. An example of a global feature is a power rail formed from metal layer M1, as discussed further below.

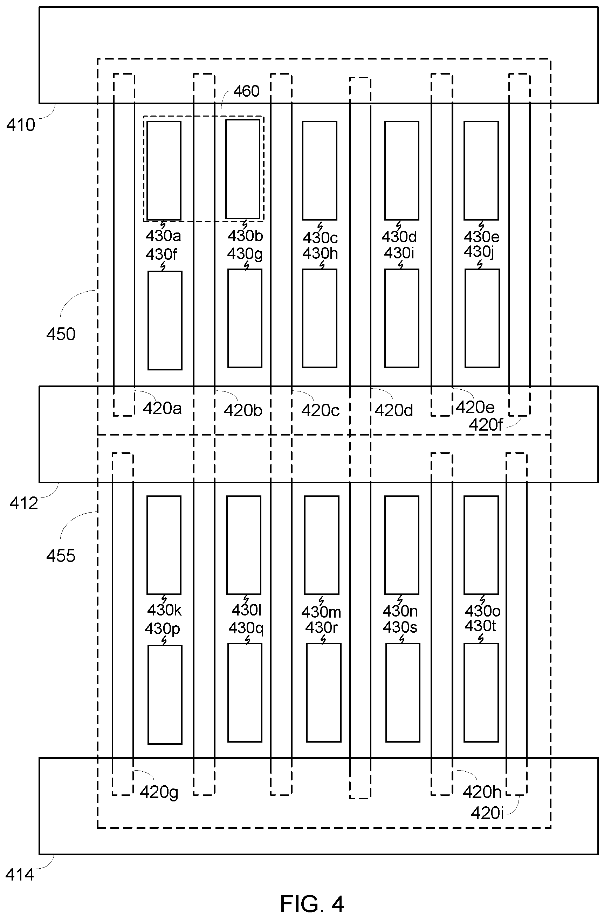

FIG. 4 shows an exemplary top view of the die 110 with metal layers M2-M9 removed for ease of illustration. In this example, the die 110 includes a first power rail 410 formed from metal layer M1, a second power rail 412 formed from metal layer M1, and a third power rail 414 formed from metal layer M1. The power rails 412 may be formed from metal layer M1 using any metal etching process known in the art. The first and third power rails 410 and 414 may have a supply voltage of Vdd and the second power rail 412 may have a supply voltage of Vss, in which Vdd may be a positive voltage and Vdd may be approximately zero volts (e.g., ground) or another voltage lower than Vdd. Alternatively, the first and third power rails 410 and 414 may have a supply voltage of Vss and the second power rail 412 may have a supply voltage of Vdd. It is to be appreciated that each of the power rails 410, 412 and 414 may be longer than shown in FIG. 4. In FIG. 4, structures under the power rails 410, 412 and 414 are shown in dashed lines.

The die includes a first cell 450 and a second cell 455. In the example in FIG. 4, a boundary between the first and second cells 450 and 455 lies under the second power rail 412, although it is to be appreciated that this need not be the case. It is to be appreciated that the die may include many more cells than shown in FIG. 4.

The first cell 450 includes multiple gates 420a-420f (e.g., polysilicon gates) and multiple sources/drains 430a-430j, which form multiple transistors within the first cell 450. In this regard, FIG. 4 shows an example of a transistor 460 formed from gate 420b, source/drain 430a and source/drain 430b. In the example in FIG. 4, the gates 420a-420f are elongated and arranged in parallel with one or more sources/drains between adjacent gates. For the example in which the gates 420a-420f include polysilicon, the gates may be referred to as poly conductors (PCs).

The transistors within the first cell 450 may be interconnected by local interconnects (not shown in FIG. 4) to form an integrated circuit that performs one or more functions. For example, the transistor may be interconnected to form a circuit that performs a logic function (AND gate, OR gate, XOR gate, etc.), a circuit that performs a storage function (flip-flop, latch, etc.), a circuit that performs a multiplexing function (e.g., multiplexer), etc. The transistors within the first cell 450 may be powered by the first and second power rails 410 and 412, which provide voltages Vdd and Vss, as discussed above. In this regard, one or more of the transistors within the first cell 450 may be coupled to the power rails by one or more contact structures (e.g., contact structures 250 and 350 shown in FIGS. 2 and 3).

The second cell 455 includes multiple gates 420b-420d, 420g, 420h and 420i (e.g., polysilicon gates) and multiple sources/drains 430k-430t, which form multiple transistors within the second cell 455. In the example shown in FIG. 4, gates 420b-420d in the first cell 450 extend underneath the second power rail 412 into the second cell 455. In the example in FIG. 4, the gates 420b-420d, 420g, 420h and 420i are elongated and arranged in parallel with one or more sources/drains between adjacent gates.

The transistors within the second cell 455 may be interconnected by local interconnects (not shown in FIG. 4) to form an integrated circuit that performs one or more functions (e.g., any of the functions discussed above). The transistors within second cell 455 may be powered by the second and third power rails 412 and 414, which provide voltages Vdd and Vss, as discussed above. In this regard, one or more of the transistors within the second cell 455 may be coupled to the power rails by one or more contact structures (e.g., contact structures 250 and 350 shown in FIGS. 2 and 3).

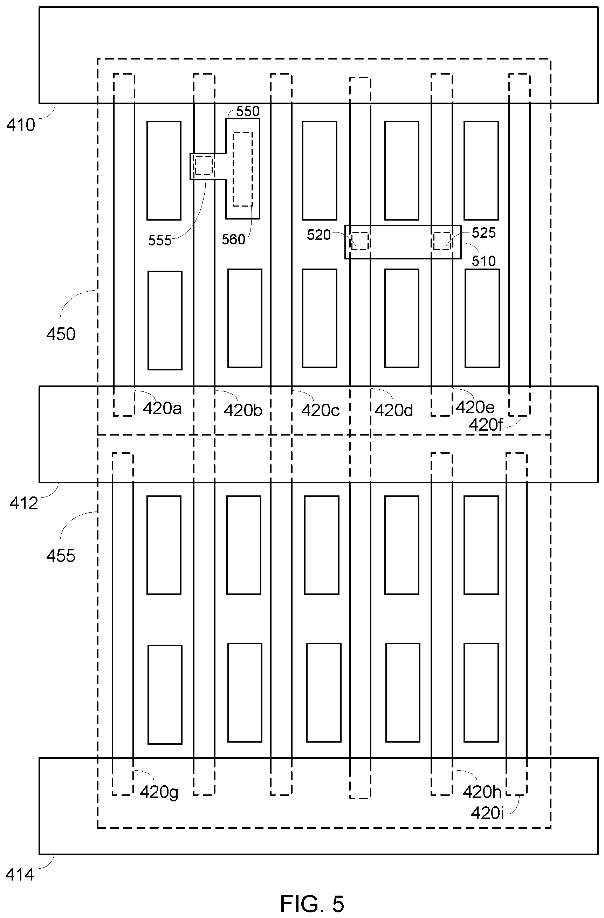

As discussed above, transistors in a cell may be interconnected to form a circuit. In this regard, FIG. 5 shows an example of a first local interconnect 510 and a second local interconnect 550 in the first cell 450, where each local interconnect is formed from metal layer M1. For ease of illustration, the references numbers for the sources/drains 430a-430t shown in FIG. 4 are omitted from FIG. 5.

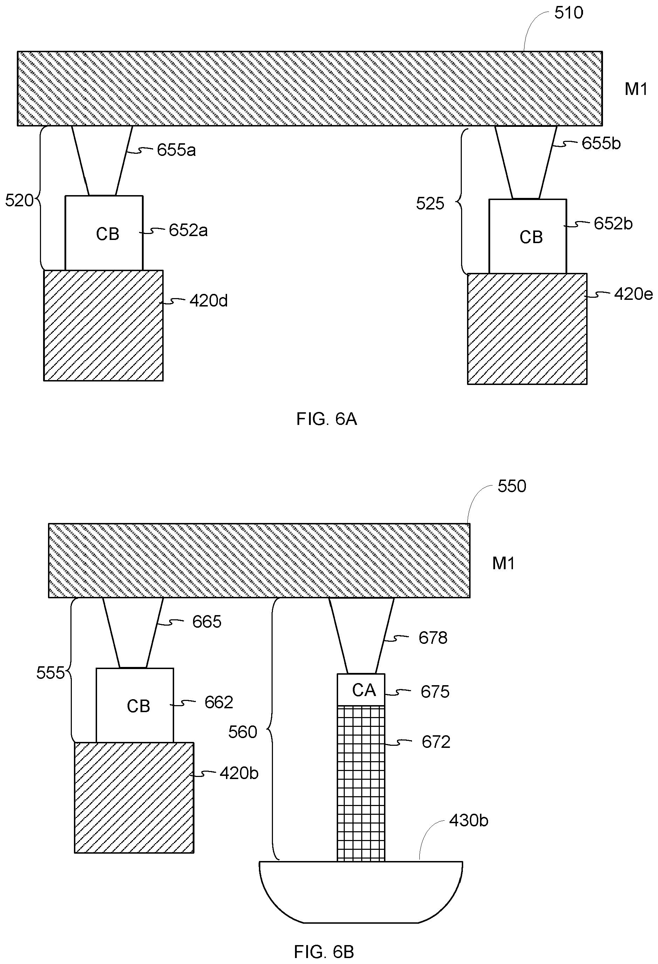

In this example, the first local interconnect 510 couples gates 420d and 420e, in which the first local interconnect 510 is coupled to gate 420d by a first contact structure 520 and is coupled to gate 420e by a second contact structure 525. In this regard, FIG. 6A shows a side view of the first local interconnect 510, in which the first contact structure 520 includes a first gate contact 652a and a first via 655a, and the second contact structure 520 includes a second gate contact 652b and a second via 655b.

Returning to FIG. 5, the second local interconnect 550 couples gate 420b and source/drain 430b, in which the second local interconnect 550 is coupled to gate 420d by a third contact structure 555 and is coupled to source/drain 430b by a fourth contact structure 560. In this regard, FIG. 6B shows a side view of the second local interconnect 550, in which the third contact structure 555 includes a gate contact 662 and a first via 665, and the fourth contact structure 560 includes a first source/drain contact 672 (e.g., TS), a second source/drain contact 675, and a second via 678.

In general, metal layer M1 may be used to form local interconnects that interconnect gates, interconnect one or more gates to one or more sources/drains, interconnect sources/drains, etc. Thus, metal layer M1 may be patterned to form local interconnects that interconnect the transistors in a cell to form a circuit. As discussed further below, metal layer M1 can also be used to form global interconnects between two or more cells.

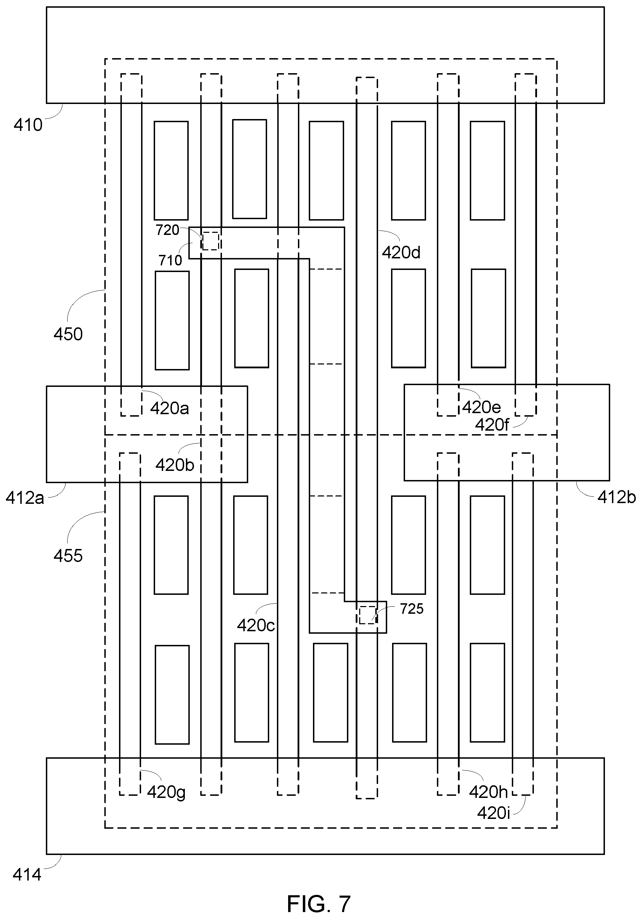

FIG. 7 shows an example in which metal layer M1 is used to form an interconnect 710 that couples transistors in the first and second cells 450 and 455. In this example, the interconnect 710 is coupled to gate 420b in the first cell 450 by a first contact structure 720, and to gate 420d in the second cell 455 by a second contact structure 725. Each of the first and second contact structures 720 and 725 may include the contact structure 250 shown in FIG. 2. As shown in FIG. 7, the interconnect 710 provides routing between the first and second cells 450 and 455. Thus, metal layer M1 can be used for both local routing and global routing.

However, a drawback with using metal layer M1 for the interconnect 710 is that it requires a break in the second power rail 412 to pass through the second power rail 412, as shown in FIG. 7. This is because the interconnect 710 and the second power rail 412 are formed from the same metal layer (i.e., metal layer M1). In the example in FIG. 7, the second power rail 412 is broken into a first portion 412a and a second portion 412b to accommodate the interconnect 710. The break in the power rail causes power integrity degradation, which may cause time-sensitive circuits to malfunction. The power integrity degradation may include increased IR voltage drops in the power network and/or electromagnetic emissions. Another drawback is that the interconnect 710 occupies a significant area, causing metal routing congestion.

In general, metal layer M1 routing is limited when it conflicts with a structure formed from metal layer M1 such as a power rail (e.g., the second power rail 412). In this case, either the metal layer M1 routing has be routed around the structure (which may not be possible in many cases) or the structure has to be broken to allow the metal layer M1 routing to pass through (which may cause one or more of the problems discussed above).

Aspects of the present disclosure provide routing using the first and second MOL metal layers (CA and CB) that avoid one or more of the above drawbacks, as discussed further below.

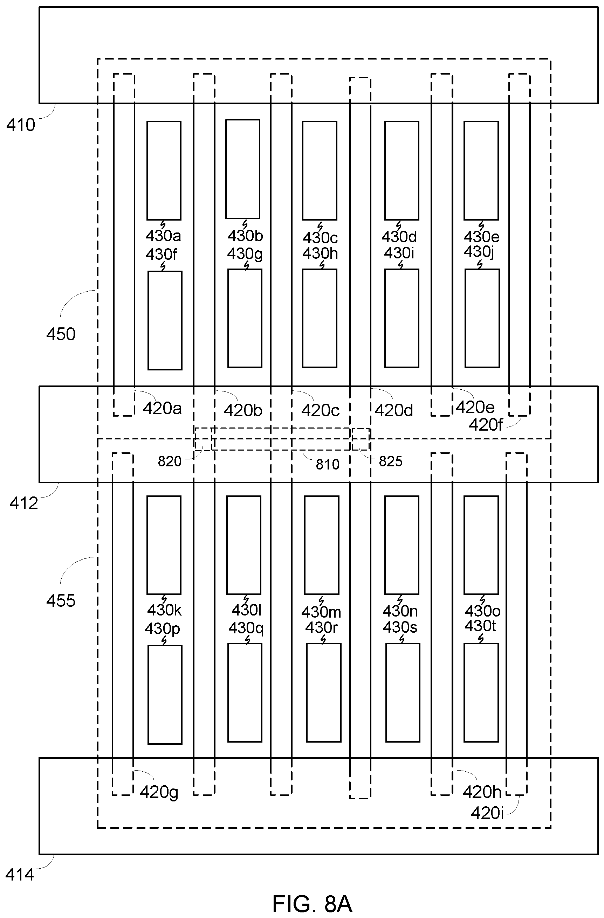

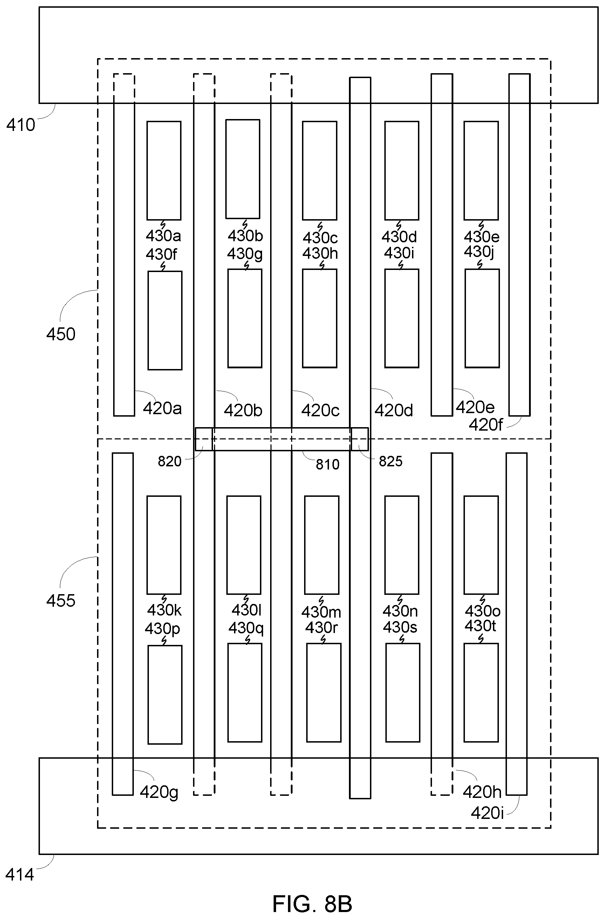

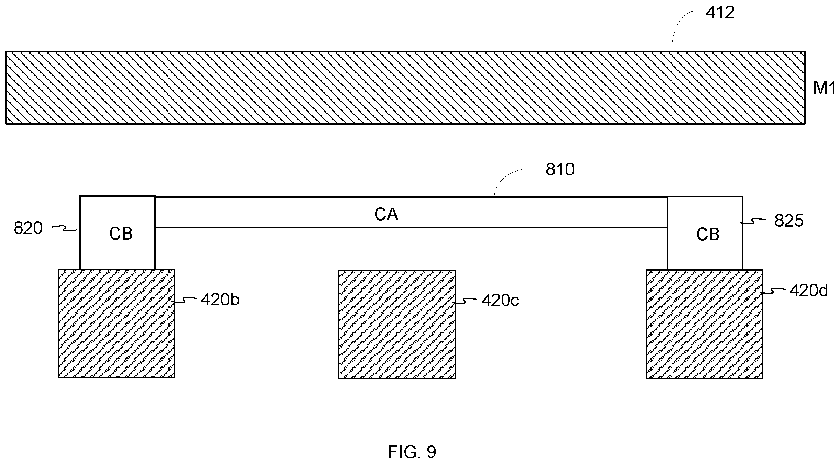

FIGS. 8A and 8B show top views of an exemplary interconnect 810 according to the invention. FIG. 8A shows the interconnect 810 with the second power rail 412, and FIG. 8B shows the interconnect 810 with the second power rail 412 removed to provide an unobstructed view of the interconnect 810. FIG. 9 shows a side view of the interconnect 810.

The interconnect 810 provides routing between gate 420b and gate 420d underneath the second power rail 412. The interconnect 810 is formed from the second MOL metal layer (CA), which is the same metal layer used to form source/drain contacts (e.g., source/drain contacts 355), as discussed above. As shown in FIG. 9, the interconnect 810 extends between and makes contact with gate contacts 820 and 825 on gates 420b and 420d, respectively. In this respect, the interconnect 810 acts as an electrical bridge between the gate contacts 820 and 825. In the example in FIG. 9, the interconnect 810 makes contact with sidewalls of the gate contacts 820 and 825.

Thus, the interconnect 810 (which is formed from the second MOL metal layer (CA)) and gate contacts 820 and 825 (which are formed from the first MOL metal layer (CB)) electrically couple gates 420b and 420d. Since the first MOL metal layer (CA) and the second MOL metal layer (CB) are formed at lower levels than metal layer M1, the interconnect 810 and gate contacts 820 and 825 are able to provide routing between gates 420b and 420d under the second power rail 412. Consequently, there is no need to break the second power rail 412. As shown in FIGS. 8A and 9, the second power rail 412 is continuous with no breaks. Further, since the interconnect 810 and gate contacts 820 and 825 are underneath metal layer M1, they do not interfere with metal layer M1, and therefore reduce routing congestion. As a result, area efficiency is improved.

Thus, aspects of the present disclosure provide MOL routing (e.g., between transistors) using the first and second MOL metal layers (CB and CA). Since the first and second MOL metal layers (CB and CA) are formed at lower levels than metal layer M1, MOL routing is not subject to the same restrictions as metal layer M1 routing. For instance, MOL routing can cross underneath a structure (e.g., power rail) formed from metal layer M1 without requiring a break in the structure. In contrast, when metal layer M1 routing conflicts with a metal layer M1 structure (e.g., power rail), the metal layer M1 routing either has be routed around the structure (which may not be possible in many cases) or the structure has to be broken to allow the metal layer M1 routing to pass through. Thus, MOL routing according to aspects of the present disclosure can advantageously be used in cases where routing using metal layer M1 would be highly restricted.

Although not explicitly shown in FIGS. 8A and 8B, it is to be appreciated that the die may also include local interconnects (e.g., local interconnects 510 and 550 as shown in FIG. 5) for interconnecting transistors in the first cell 450 and second cell 455 to form integrated circuits.

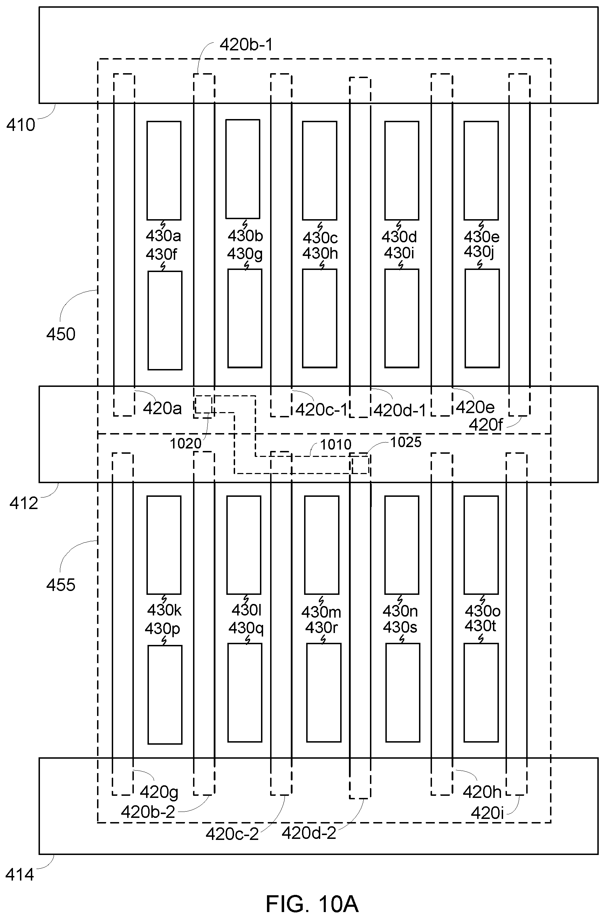

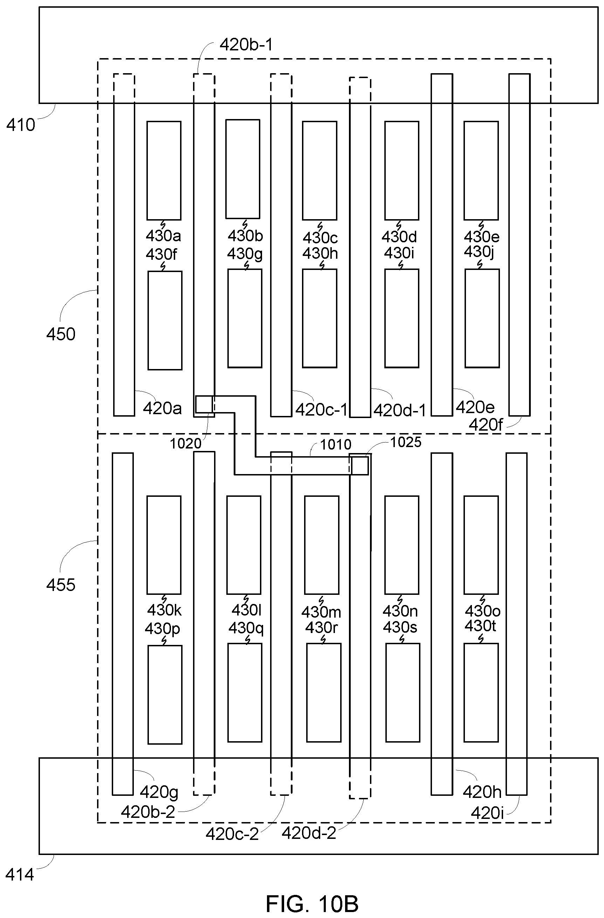

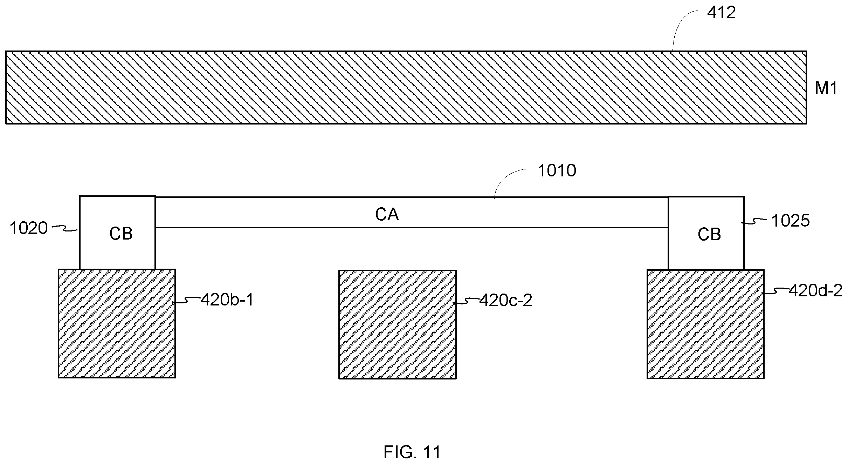

FIGS. 10A and 10B show top views of another exemplary interconnect 1010 according to the invention. FIG. 10A shows the interconnect 1010 with the second power rail 412, and FIG. 10B shows the interconnect 1010 with the second power rail 412 removed to provide an unobstructed view of the interconnect 1010. FIG. 11 shows a side view of the interconnect 1010.

In this example, gate 420b in FIG. 8 is broken into gate 420b-1 in the first cell 450 and gate 420b-2 in the second cell 455, gate 420c in FIG. 8 is broken into gate 420c-1 in the first cell 450 and gate 420c-2 in the second cell 455, and gate 420d in FIG. 8 is broken into gate 420d-1 in the first cell 450 and gate 420d-2 in the second cell 455.

In this example, the interconnect 1010 provides routing between gate 420b-1 and gate 420d-2 underneath the second power rail 412. The interconnect 1010 is formed from the second MOL metal layer (CA), which is the same metal layer used to form source/drain contacts (e.g., source/drain contacts 355), as discussed above. As shown in FIG. 11, the interconnect 1010 extends between and makes contact with gate contacts 1020 and 1025 on gates 420b-1 and 420d-2, respectively. In this respect, the interconnect 1010 acts as an electrical bridge between the gate contacts 1020 and 1025.

Thus, the interconnect 1010 (which is formed from the second MOL metal layer (CA)) and gate contacts 1020 and 1025 (which are formed from the first MOL metal layer (CB)) provide routing between gate 420b-1 in the first cell 450 and 420d-2 in the second cell. In the example in FIG. 11, the interconnect 1010 makes contact with sidewalls of the gate contacts 1020 and 1025. Since the first MOL metal layer (CA) and the second MOL metal layer (CB) are formed at lower levels than metal layer M1, the interconnect 1010 and gate contacts 1020 and 1025 are able to provide routing under the second power rail 412.

It is to be appreciated that aspects of the present disclosure are not limited to the particular examples discussed. In general, aspects of the present disclosure provide routing between cells under a metal M1 power rail (e.g., power rail 412) using an interconnect formed from the second MOL metal layer (CA). For example, the interconnect may couple a first gate in one cell to a second gate in another cell by extending between and making contact with gate contacts on the first and second gates, in which the gate contacts may be formed from the first MOL metal layer (CB). In this respect, the interconnect acts as an electrical bridge between the gate contacts. Since the second MOL metal layer (CA) is formed at a lower level than metal layer M1, the interconnect is able to pass underneath a metal M1 power rail, and therefore does not require a break in the metal M1 power rail.

In certain aspects, one or more transistors may be tied off to provide electrical isolation between semiconductor devices (transistors). In these aspects, a transistor is tied off by coupling the source and gate of the transistor together. This permanently turns off the transistor, allowing the transistor to act as an electrical barrier between semiconductor devices on opposite sides of the transistor.

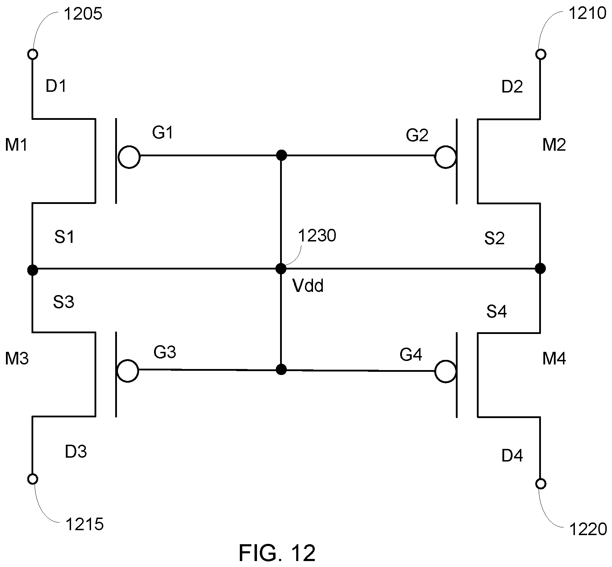

In this regard, FIG. 12 is a circuit diagram illustrating an example in which transistors M1-M4 are tied off to provide electrical isolation between nodes 1205, 1210, 1215 and 1220. In this example, the gates G1-G4 and sources S1-S4 of the transistors M1-M4 of the transistors M1-M4 are all tied to node 1230, which is coupled to supply voltage Vdd. This effectively turns off transistor M1-M4, providing an electrical barrier between nodes 1205, 1210, 1215 and 1220, which may correspond to the drains D1-D4 of the transistors M1-M4. As a result, a device (e.g., transistor) coupled to one of the nodes 1205, 1210, 1215 and 1220 is electrically isolated from the other nodes 1205, 1210, 1215 and 1220. In the example in FIG. 12, the transistors M1-M4 are p-type field effect transistors (PFETs). However, it is to be appreciated that the transistors M1-M4 may be replaced with n-type field effect transistors (NFETs) with the gates and sources of the NFETs tied to ground.

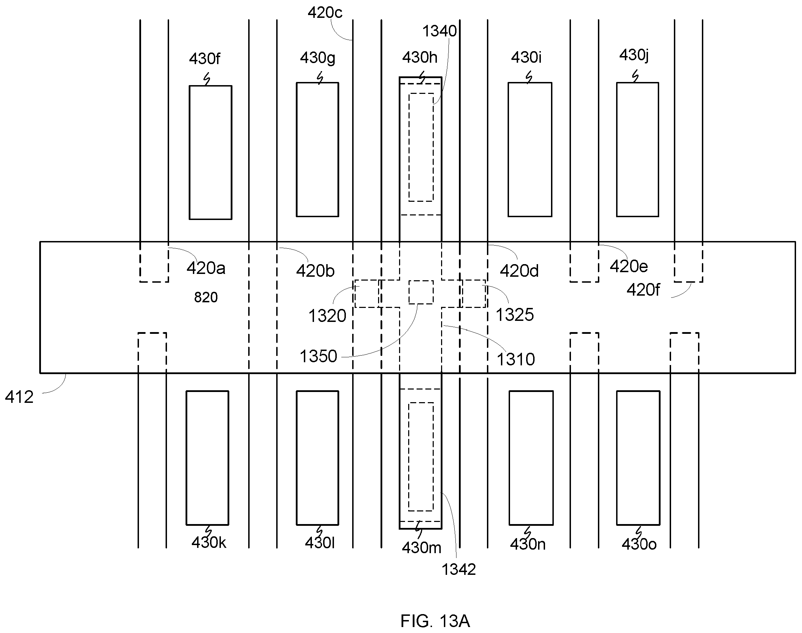

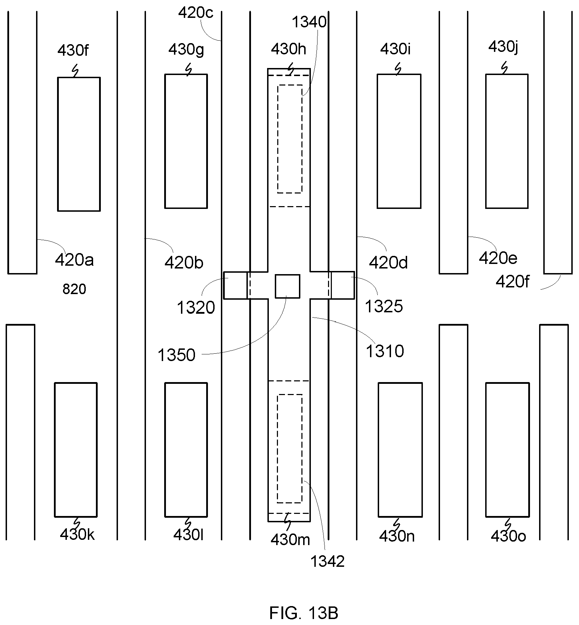

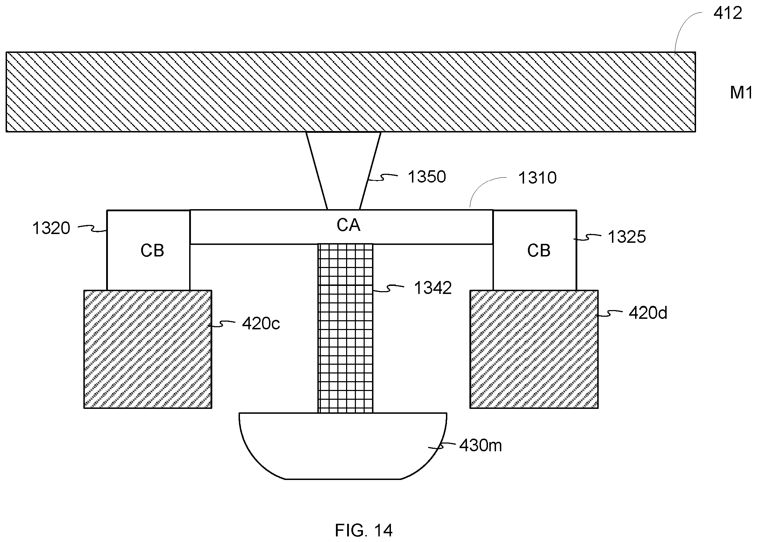

FIGS. 13A and 13B show top views of an exemplary interconnect 1310 that provides routing underneath the second power rail 412 according to the invention for implementing the exemplary circuit shown in FIG. 12. FIG. 13A shows the interconnect 1310 with the second power rail 412, and FIG. 13B shows the interconnect 1310 with the second power rail 412 removed to provide an unobstructed view of the interconnect 1310. FIG. 14 shows a side view of the interconnect 1310. The interconnect 1310 may be formed from the second MOL metal layer (CA), as discussed further below.

In this example, gate 420c and source/drain 430h may provide the gate G1 and source S1 of transistor M1, gate 420c and source/drain 430m may provide the gate G2 and source S2 of transistor M2, gate 420d and source/drain 430h may provide the gate G3 and source S3 of transistor M3, and gate 420d and source/drain 430m may provide the gate G4 and source S4 of transistor M4. Thus, gate 420c may provide the gates G1 and G2 for both transistors M1 and M2, and gate 420 may provide the gates G3 and G4 for both transistors M3 and M4. Similarly, source/drain 430h may provide the sources S1 and S3 for both transistors M1 and M3, and source/drain 430m may provide the sources S2 and S4 for both transistors M2 and M4. Sources/drains 430g, 430l, 430i and 430n may provide the drains D1-D4, respectively, of the transistors M1-M4.

In this example, the interconnect 1310 extends between and makes contact with gate contacts 1320 and 1325 on gates 420c and 420d, respectively. As a result, the interconnect 1310 and gate contacts 1320 and 1325 couple the gates G1-G4 of the transistors M1-M4 together. In the example shown in FIG. 14, the interconnect 1310 makes contact with sidewalls of the gate contacts 1320 and 1325.

The interconnect 1310 is also coupled to source/drain 430h and source/drain 430m. In this example, the interconnect 1310 is coupled to source/drain 430 by source/drain contact 1340 (e.g., TS source/drain contact) disposed between the interconnect 1310 and source/drain 430h, and coupled to source/drain 430m by source/drain contact 1342 (e.g., TS source/drain contact) disposed between the interconnect 1310 and source/drain 430m. In the example shown in FIG. 14, the interconnect 1310 makes contact with the tops of the source/drain contacts 1340 and 1342 (e.g., TS source/drain contacts).

Thus, the interconnect 1310 couples the gates G1-G4 of the transistors M1-M4 together and couples the sources S1-S4 of the transistors M1-M4 together. As a result, the gates G1-G4 and sources S1-S4 of the transistors M1-M4 are all coupled together.

The interconnect 1310 is also coupled to the second power rail 412 by via 1350 disposed between the interconnect 1310 and the second power rail 412. In one example, the second power rail 412 provides supply voltage Vdd and the transistors M1-M4 are PFETs. As a result, in this example, the gates G1-G4 and sources S1-S4 of the transistors M1-M4 are tied to Vdd. This effectively turns off the transistors M1-M4, providing an electrical barrier between the first cell 450 and the second cell 455, and more particularly between sources/drains 430g, 430l, 430i and 430n.

Thus, the interconnect 1310 (which is formed from the second MOL metal layer (CA)) provides routing under the second power supply 412 for tying off the transistors M1-M4 to form an electrical barrier. It is to be appreciated that aspects of the present disclosure are not limited to the example shown in FIGS. 12-14. In general, aspects of the present disclosure may tie off one or more transistors by using an interconnect formed from the second MOL metal layer (CA), in which the interconnect is coupled the gate and source of each transistor. The interconnect may also be coupled to a metal M1 power rail by a via between the interconnect and the power rail. For the example in which the one or more transistors are PFETs, the power rail may provide supply voltage Vdd. For the example in which the one or more transistors are NFETs, the power rail may provide supply voltage Vss.

## Claims

1. A semiconductor die (110), comprising:
a power rail (412) formed from a first metal layer (M1);
a first gate (420b, 420b-1);
a second gate (420d, 420d-1);
a first gate contact (820, 1020) electrically coupled to the first gate, wherein the first gate contact is formed from a first middle of line, MOL, (CB) metal layer;
a second gate contact (825, 1025) electrically coupled to the second gate, wherein the second gate contact is formed from the first MOL metal layer (CB); and
an interconnect (810, 1010) formed from a second MOL metal layer (CA),
wherein the interconnect is electrically coupled to the first and second gate contacts, and acts as electrical bridge between the first and the second gate contacts, and the interconnect is parallel to, spaced apart from and underneath the power rail,
wherein further the first and second MOL metal layers (CB, CA) are formed at lower levels than the first metal layer (Ml).

2. The semiconductor die of claim 1, wherein the interconnect makes contact with sidewalls of the first and second gate contacts, and wherein the interconnect (810, 1010) extends laterally between a sidewall of the first gate contact (820, 1020) and a sidewall of the second gate contact (825, 1025).

3. The semiconductor die of claim 1, further comprising:
a source, wherein the interconnect is electrically coupled to the source; and
a via electrically coupled between the interconnect and the power rail.

4. The semiconductor die of claim 3, further comprising a source contact disposed between the source and the interconnect.

5. The semiconductor die of claim 4, wherein the source contact comprises trench silicide.

6. The semiconductor die of claim 3, wherein the source and the first gate are part of a p-type field effect transistor, PFET, and the power rail has a supply voltage of Vdd.

7. The semiconductor die of claim 3, wherein the source and the first gate are part of an n-type field effect transistor, NFET, and the power rail is grounded.

8. The semiconductor die of claim 1, further comprising:
a first source, wherein the first source and the first gate are part of a first transistor;
a second source, wherein the second source and the second gate are part of a second transistor, and the interconnect is electrically coupled to the first source and the second source; and
a via electrically coupled between the interconnect and the power rail.

9. The semiconductor die of claim 1, further comprising:
a source/drain;
a source/drain contact electrically coupled to the source/drain, wherein the source/drain contact is formed from the second MOL metal layer; and
a via electrically coupled between the source/drain contact and the power rail.

10. A semiconductor die (110), comprising:
a power rail (412) formed from a first metal layer (M1);
a gate;
a source;
a gate contact electrically coupled to the gate, wherein the gate contact is formed from a first middle of line, MOL, metal layer (CB); and
an interconnect formed from a second MOL metal layer (CA), wherein the interconnect is electrically coupled to the gate contact and the source, and acts as electrical bridge between the gate and the source contacts, and the interconnect is parallel to, spaced apart from and underneath the power rail, wherein further the first and second MOL metal layers (CB, CA) are formed at lower levels than the first metal layer (Ml).

11. The semiconductor die of claim 10, wherein the source contact comprises trench silicide.

12. The semiconductor die of claim 10, wherein the interconnect makes contact with a sidewall of the gate contact, and wherein the interconnect extends laterally from the sidewall of the first gate contact.

13. The semiconductor die of claim 10, further comprising a via electrically coupled between the interconnect and the power rail.

14. The semiconductor die of one of the preceding claims, wherein the semiconductor die forms a semiconductor chip (110).

## Patentansprüche

1. Ein Halbleiter-Die (110), der Folgendes aufweist:
eine Leistungsschiene (412), die aus einer ersten Metallschicht (M1) gebildet ist;
ein erstes Gate (420b, 420b-1);
ein zweites Gate (420d, 420d-1);
einen ersten Gate-Kontakt (820, 1020), der elektrisch an das erste Gate gekoppelt ist, wobei der erste Gate-Kontakt aus einer ersten Mittellinien- bzw. MOL-Metallschicht (MOL = middle of line) (CB) gebildet wird;
einen zweiten Gate-Kontakt (825, 1025), der elektrisch an das zweite Gate gekoppelt ist, wobei der zweite Gate-Kontakt aus der ersten Mittellinien- bzw. MOL-Metallschicht (MOL = middle of line) (CB) gebildet wird; und
ein Interconnect (810, 1010), das aus einer zweiten Mittellinien- bzw. MOL-Metallschicht (MOL = middle of line) (CA) gebildet wird, wobei das Interconnect elektrisch an die ersten und zweiten Gate-Kontakte gekoppelt ist, und als eine elektrische Brücke zwischen den ersten und zweiten Gate-Kontakten wirkt, und das Interconnect parallel zu, beabstandet von und unter der Leistungsschiene ist,
wobei weiter die erste und zweite MOL-Metallschicht (CB, CA) auf niedrigeren Ebenen ausgebildet sind als die erste Metallschicht (M1).

2. Halbleiter-Die nach Anspruch 1, wobei das Interconnect Seitenwände des ersten und zweiten Gate-Kontakts kontaktiert, und wobei sich das Interconnect (810, 1010) seitlich bzw. lateral zwischen einer Seitenwand des ersten Gate-Kontakts (820, 1020) und einer Seitenwand des zweiten Gate-Kontakts (825, 1025) erstreckt.

3. Halbleiter-Die nach Anspruch 1, der weiter Folgendes aufweist:
eine Source, wobei das Interconnect elektrisch an die Source gekoppelt ist; und
ein Via bzw. eine Durchkontaktierung, die elektrisch zwischen das Interconnect und die Leistungsschiene gekoppelt ist.

4. Halbleiter-Die nach Anspruch 3, der weiter einen Source-Kontakt aufweist, der zwischen der Source und dem Interconnect angeordnet ist.

5. Halbleiter-Die nach Anspruch 4, wobei der Source-Kontakt Grabensilizid aufweist.

6. Halbleiter-Die nach Anspruch 3, wobei die Source und das erste Gate Teil eines p-Typ-Feldeffekttransistors bzw. PFET (PFET = p-type field effect transistor) sind, und die Leistungsschiene eine Versorgungsspannung von Vdd hat.

7. Halbleiter-Die nach Anspruch 3, wobei die Source und das erste Gate Teil eines n-Typ-Feldeffekttransistors bzw. NFET (NFET = n-type field effect transistor) sind und die Leistungsschiene mit Masse verbunden ist.

8. Halbleiter-Die nach Anspruch 1, der weiter Folgendes aufweist:
eine erste Source, wobei die erste Source und das erste Gate Teil eines ersten Transistors sind;
eine zweite Source, wobei die zweite Source und das zweite Gate Teil eines zweiten Transistors sind, und das Interconnect elektrisch an die erste Source und die zweite Source gekoppelt ist; und
ein Via bzw. eine Durchkontaktierung elektrisch zwischen das Interconnect und die Leistungsschiene gekoppelt ist.

9. Halbleiter-Die nach Anspruch 1, der weiter Folgendes aufweist:
eine Source/Drain;
einen Source/Drain-Kontakt, der elektrisch an die Source/Drain gekoppelt ist, wobei der Source/Drain-Kontakt aus der zweiten MOL-Metallschicht gebildet ist; und
ein Via bzw. eine Durchkontaktierung, die elektrisch zwischen den Source/Drain-Kontakt und die Leistungsschiene gekoppelt ist.

10. Ein Halbleiter-Die (110), der Folgendes aufweist:
eine Leistungsschiene (412), die aus der ersten Metallschicht (M1) gebildet ist;
ein Gate;
eine Source;
einen Gate-Kontakt, der elektrisch an das Gate gekoppelt ist, wobei der Gate-Kontakt aus einer ersten Mittellinien- bzw. MOL-Metallschicht (MOL = middle of line) (CB) gebildet ist; und
ein Interconnect, das aus einer zweiten MOL-Metallschicht (CA) gebildet ist, wobei das Interconnect elektrisch an den Gate-Kontakt und die Source gekoppelt ist, und als eine elektrische Brücke zwischen dem Gate und den Source-Kontakten dient, und das Interconnect parallel zu, beabstandet von und unter der Leistungsschiene ist, wobei weiter die erste und zweite MOL-Metallschicht (CB, CA) auf niedrigeren Ebene ausgebildet sind als die erste Metallschicht (M1).

11. Halbleiter-Die nach Anspruch 10, wobei der Source-Kontakt Grabensilizid aufweist.

12. Halbleiter-Die nach Anspruch 10, wobei das Interconnect eine Seitenwand des Gate-Kontakts kontaktiert, und wobei sich das Interconnect lateral bzw. seitlich von der Seitenwand des ersten Gate-Kontakts erstreckt.

13. Halbleiter-Die nach Anspruch 10, der weiter ein Via aufweist, das elektrisch zwischen das Interconnect und die Leistungsschiene gekoppelt ist.

14. Halbleiter-Die nach einem der vorhergehenden Ansprüche, wobei der Halbleiter-Die einen Halbleiter-Chip (110) bildet.

## Revendications

1. Puce semiconductrice (110), comprenant :
un rail d'alimentation (412) formé à partir d'une première couche métallique (M1) ;
une première grille (420b, 420b-1) ;
une deuxième grille (420d, 420d-1) ;
un premier contact de grille (820, 1020) relié électriquement à la première grille, dans laquelle le premier contact de grille est formé à partir d'une première couche métallique au milieu de la ligne, MOL, (CB) ;
un deuxième contact de grille (825, 1025) relié électriquement à la deuxième grille, dans laquelle le deuxième contact de grille est formé à partir de la première couche métallique MOL (CB) ; et
une interconnexion (810, 1010) formée à partir d'une deuxième couche métallique MOL (CA), dans laquelle l'interconnexion est reliée électriquement aux premier et deuxième contacts de grille, et agit comme un pont électrique entre les premier et deuxième contacts de grille, et l'interconnexion est parallèle au, espacée et au-dessous du rail d'alimentation,
dans laquelle en outre les première et deuxième couches métalliques MOL (CB, CA) sont formées à des niveaux inférieurs à celui de la première couche métallique (Ml).

2. Puce semiconductrice selon la revendication 1, dans laquelle l'interconnexion établit un contact avec des parois latérales des premier et deuxième contacts de grille, et dans laquelle l'interconnexion (810, 1010) s'étend latéralement entre une paroi latérale du premier contact de grille (820, 1020) et une paroi latérale du deuxième contact de grille (825, 1025).

3. Puce semiconductrice selon la revendication 1, comprenant en outre :
une source, dans laquelle l'interconnexion est reliée électriquement à la source ; et
un via relié électriquement entre l'interconnexion et le rail d'alimentation.

4. Puce semiconductrice selon la revendication 3, comprenant en outre un contact de source disposé entre la source et l'interconnexion.

5. Puce semiconductrice selon la revendication 4, dans laquelle le contact de source comprend un siliciure en tranchée.

6. Puce semiconductrice selon la revendication 3, dans laquelle la source et la première grille font partie d'un transistor à effet de champ de type p, PFET, et le rail d'alimentation a une tension d'alimentation de Vdd.

7. Puce semiconductrice selon la revendication 3, dans laquelle la source et la première grille font partie d'un transistor à effet de champ de type n, NFET, et le rail d'alimentation est mis à la masse.

8. Puce semiconductrice selon la revendication 1, comprenant en outre :
une première source, dans laquelle la première source et la première grille font partie d'un premier transistor ;
une deuxième source, dans laquelle la deuxième source et la deuxième grille font partie d'un deuxième transistor, et l'interconnexion est reliée électriquement à la première source et à la deuxième source ; et
un via relié électriquement entre l'interconnexion et le rail d'alimentation.

9. Puce semiconductrice selon la revendication 1, comprenant en outre :
une source/un drain ;
un contact de source/drain relié électriquement à la source/au drain, dans laquelle le contact est formé à partir de la deuxième couche métallique MOL ; et
un via relié électriquement entre le contact de source/drain et le rail d'alimentation.

10. Puce semiconductrice (110), comprenant :
un rail d'alimentation (412) formé à partir d'une première couche métallique (Ml) ;
une grille ;
une source ;
un contact de grille relié électriquement à la grille, dans laquelle le contact de grille est formé à partir d'une première couche métallique au milieu de la ligne, MOL, (CB) ; et
une interconnexion formée à partir d'une deuxième couche métallique MOL (CA), dans laquelle l'interconnexion est reliée électriquement au contact de grille et à la source, et agit comme pont électrique entre les contacts de grille et de source, et l'interconnexion est parallèle au, espacée et au-dessous du rail d'alimentation, dans laquelle en outre les première et deuxième couches métalliques MOL (CB, CA) sont formées à des niveaux inférieurs à celui de la première couche métallique (Ml).

11. Puce semiconductrice selon la revendication 10, dans laquelle le contact de source comprend un siliciure en tranchée.

12. Puce semiconductrice selon la revendication 10, dans laquelle l'interconnexion établit un contact avec une paroi latérale du contact de grille, et dans laquelle l'interconnexion s'étend latéralement à partir de la paroi latérale du premier contact de grille.

13. Puce semiconductrice selon la revendication 10, comprenant en outre un via relié électriquement entre l'interconnexion et le rail d'alimentation.

14. Puce semiconductrice selon l'une des revendications précédentes, dans laquelle la puce semiconductrice forme une puce semiconductrice (110).
